Europäisches Patentamt

(19) European Patent Office

Office européen des brevets

(11) Numéro de publication: **0 121 464**
**B1**

(12) **FASCICULE DE BREVET EUROPÉEN**

(45) Date de publication du fascicule du brevet:
18.03.87

(51) Int. Cl.⁴: **G 11 C 11/00,** H 01 L 29/60,
H 01 L 27/10

(21) Numéro de dépôt: 84400563.7

(22) Date de dépôt: 20.03.84

(54) **Cellule de mémoire RAM non volatile à transistors CMOS à grille flottante commune.**

(30) Priorité: 31.03.83 FR 8305360

(43) Date de publication de la demande:
10.10.84 Bulletin 84/41

(45) Mention de la délivrance du brevet:
18.03.87 Bulletin 87/12

(84) Etats contractants désignés:
DE FR IT NL

(56) Documents cité:
DE-A-2 622 307
US-A-4 193 128
US-A-4 300 212

IBM TECHNICAL DISCLOSURE BULLETIN, vol. 24,
no. 5, octobre 1981, NEW YORK (US); H.H.ChAO:
"Static ram with nonvolatile backup memory", pp.
2456-2457

(73) Titulaire: SOCIETE POUR L'ETUDE ET LA
FABRICATION DE CIRCUITS INTEGRES
SPECIAUX - E.F.C.I.S., 17, avenue des Martyrs,
F-38100 Grenoble (FR)

(72) Inventeur: Bétirac, Michel, c/o THOMSON- CSF
SCPI 173 bld Haussmann, F-75379 Paris Cédex 08
(FR)

(74) Mandataire: Guérin, Michel, THOMSON- CSF SCPI
19, avenue de Messine, F-75008 Paris (FR)

## Description

La présente invention concerne les mémoires intégrées du type mémoire vive à fonctionnement statique (RAM statiques).

On sait que ces mémoires sont appelées mémoires vives car elles ne conservent une information que si elles ne cessent pas d'être alimentées: une coupure accidentelle de courant efface l'information.

On cherche de plus en plus à prévoir des moyens pour sauvegarder l'information, avant qu'elle ne se perde par coupure de courant, dans un élément de mémoire permanente associé à chaque cellule de mémoire vive. On appelle alors ces mémoires des mémoires vives non volatiles, qui se distinguent des mémoires vives pures parce qu'elles sauvegardent l'information stockée même en cas de coupure d'alimentation, et qui se distinguent des mémoires permanentes car, en dehors des moments d'enregistrement non volatile des informations, elles fonctionnent comme des memoires vives, c'est à dire notamment avec une grande vitesse et une grande facilité de lecture et d'écriture.

On a déjà proposé des mémoires vives non volatiles, et notamment des mémoires qui utilisent comme élément de mémorisation des transistors MOS (Metal Oxyde Semiconducteur) complémentaires à grille flottante.

On peut se référer par exemple au brevet US 4 128 773 de Troutman qui montre une cellule de mémoire vive qui est une bascule bistable classique à quatre transistors, alimentée entre deux bornes d'alimentation Vss et Vdd. L'élément de mémorisation est essentiellement un ensemble en série de deux transistors complémentaires, l'un à canal n, l'autre à canal p, cet ensemble en série étant placé entre les bornes Vss et Vdd et possédant une grille flottante commune et une grille de commande commune reliée à une sortie de la bascule alors que le point de jonction des deux transistors complémentaires est relié à l'autre sortie (complémentaire) de la bascule. Une zone d'injection de charges électriques dans la grille flottante est prévue du côté du point de jonction des deux transistors complémentaires.

Cet ensemble constitue bien une celule de mémoire vive non volatile, mais il présente deux types d'inconvénients. Le premier inconvénient est le fait que lorsqu'on a enregistré l'information non volatile, par exemple lors d'une coupure de courant, et qu'on veut remettre ensuite la bascule dans un état correspondant à l'information ainsi sauvegardée, il se trouve qu'en fait la bascule se repositionne dans l'état inverse de celui qu'elle avait au départ. Il y a bien une sauvegarde de l'information, mais l'information retrouvée doit être complémentée pour revenir à sa valeur vraie. Le deuxième inconvénient est la dissymétrisation de la bascule: selon l'état de l'élément de mémorisation permanente, on retrouve sur l'une ou l'autre des branches de la bascule l'équivalent d'un transistor en parallèle qui fausse l'équilibre de la bascule: la bascule de mémorisation perturbe le fonctionnement normal en mémoire vive de la bascule.

La présente invention propose une celule de mémoire non volatile différente qui ne présente pas ces inconvénients.

Un autre exemple de mémoire non-volatile est décrit dans US-A- 4 193 128, mais il est conçu pour stocker de manière non volatile plusieurs états successifs de la cellule de mémoire sans effacement des états précédents.

La celule selon l'invention comprend également une bascule bbistable à deux sorties complémentaires, alimentée par une tension continue; un élément de mémorisation non volatile est connecté entre les deux sorties complémentaires de la bascule et cet élément comporte un ensemble de deux transistors MOS complémentaires, à savoir un transistor à canal n, et un transistor à canal p, ces deux transistors ayant une grille flottante commune recouvrant leurs régions de canal, et isolée d'elles par une première couche isolante mince, et une grille de commande commune recouvrant aumoins partiellement la grille flottante et isolée d'elle par une deuxième couche isolante mince, la première couche isolante présentant une zone très mince du côté de la région de source de l'un des transistors complémentaires, cette région de source étant reliée à une première sortie de la bascule, et la grille de commande étant reliée à la deuxième sortie; la cellule comprend encore un moyen pour appliquer temporairement un potentiel d'alimentation entre chacun des deux transistors complémentaires et la sortie à laquelle il est directement ou indirectement relié.

Les transistors complémentaires peuvent être reliés en série et leur point de jonction est alors relié par un transistor ou une capacité à la tension d'alimentation. Si c'est un transistor, il reçoit sur sa grille un signal de commande de repositionnement pour remettre la bascule dans son état original après une interruption de l'alimentation.

Pour améliorer les conditions d'enregistrement non volatile lors d'une opération de sauvegarde, on peut prévoir des transistors MOS supplémentaires en série avec les deux transistors complémentaires, entre les deux sorties de la bascule, et notamment un transistor relié entre la première sortie de la bascule et les transistors complémentaires, ce transistor étant commandé par un signal de repositionnement, ou encore un groupe de deux transistors en série, connecté entre les mêmes points, ayant leurs grilles reliées l'une à la deuxième sortie de la bascule et l'autre au point de jonction des deux transistors complémentaires.

D'autres caractéristiques et avantages de l'invention apparaîtront à la lecture de la description détaillée qui suit et qui est faite en référence aux dessins annexés dans lesquels:

- la figure 1 représente le schéma de base de la cellule de mémoire vive non volatile selon l'invention;

- la figure 2 représente en coupe transversale la structure schématique de l'élément de mémorisation;

- la figure 3 représente une variante de réalisation de la cellule non volatile;

- les figures 4 et 5 représentent deux autres variantes.

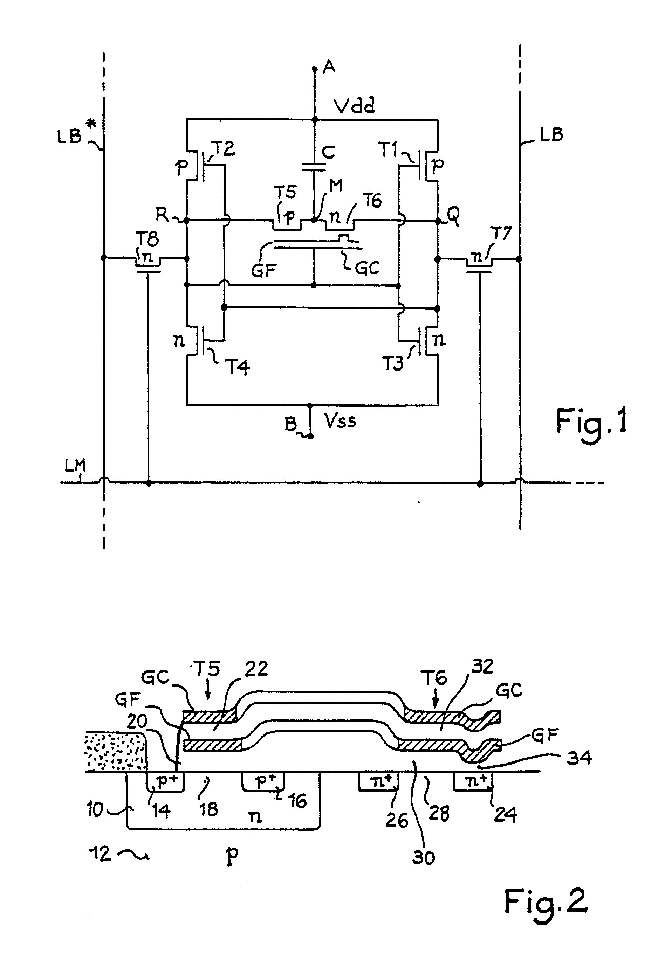

La cellule de mémoire de la figure 1 comprend une bascule bistable classique, alimentée entre deux bornes d'alimentation en tension continue A (tension Vdd) et B (tension Vss). Cette bascule comprend quatre transistors MOS T1, T2, T3, T4. Les transistors T1 et T3 sont en série entre les bornes A et B, les transistors T2 et T4 également. La grille du transistor T4 est reliée au point de jonction Q des transistors T1 et T3, et la grille du transistor T3 est reliée au point de jonction R des transistors T2 et T4. Les points Q et R sont les deux sorties complémentaires de la bascule, reliées respectivement la première par un transistor T7 à une ligne de bit LB, la seconde par un transistor T8 à une ligne de bit complémentaire LB*. Les transistors T7 et T8 sont commandés tous deux par une ligne de mots LM.

Les transistors T3 et T4 sont des transistors à canal n, ayant des caractéristiques électriques sensiblement équivalentes, tandis que les transistors T1 et T2 sont à canal p et ont également des caractéristiques sensiblement équivalentes. La grille du transistor T1 est reliée à celle du transistor T3, celle du transistor T2 à celle du transistor T4.

L'élément de mémorisation est constitué par un ensemble en série d'un transistor MOS à canal p, T5, et d'un transistor MOS à canal n, T6. Ces transistors ont une grille flottante commune GF et une grille de commande commune GC. Cette dernière est reliée à la sortie R de la bascule. L'ensemble en série des deux transistors complémentaires T5 et T6 est connecté entre les bornes Q et R. Une zone d'injection d'électrons dans la grille flottante GF est prévue, du côté de la sortie Q, dans le transistor à canal n, T6, relié à cette sortie.

Une capacité C est reliée entre le point de jonction M des transistors complémentaires et la borne d'alimentation A.

Pour éviter des ambiguités dans la description, on appellera source des transistors T5 et T6 le côté relié aux sorties Q et R, et drain le côté du point de jonction. Ainsi, la zone d'injection est prévue du côté de la source du transistor à canal n T6.

La figure 2 représente la structure de l'ensemble en série des deux transistors complémentaires T5 et T6; cette figure est schématique et ne prétend pas décrire complètement la topologie et les détails de réalisation de la structure, celle-ci étant réalisée selon les techniques de fabrication des transistors à grille flottante.

Le transistor T5 à canal p est par exemple formé à l'intérieur d'un caisson 10 de type n diffusé à l'intérieur d'un substrat semiconducteur 12 de type p. Ce transistor comporte une region de source 14 de type p+, une région de drain 16 de type p+, et, entre les deux, une région de canal 18 de type n. La région de canal est recouverte d'une première couche isolante mince 20, elle-même recouverte d'une grille flottante conductrice GF. La grille flottante GF est recouverte d'une deuxième couche mince isolante 22, elle-même recouverte d'une grille de commande GC.

Le transistor T6, à canal n, est formé directement dans le substrat et comporte une région de source 24 de type n+, une région de drain 26, également de type n+ et reliée par une connexion non représentée à la région de drain du transistor T5, et, entre la région de source et la région de drain, une région de canal 28 recouverte d'une couche isolante mince 30, elle-même surmontée d'une grille flottante conductrice qui est la même grille GF qui recouvre le transistor T5. Cette grille GF est surmontée d'une autre couche isolante 32 et d'une grille de commande GC qui est la même grille GC qui recouvre le transistor T5.

Il est prévu une zone 34 d'amincissement de la couche isolante 30, au dessus de la région de source 24 ou de la région de canal 28 du transistor à canal n T6; cette zone constitue une zone mince pour faciliter l'injection de charges électriques à travers la couche isolante 30 dans la grille flottante GF. La couche 30 peut avoir une épaisseur de quelques dizaines de nm, mais de quelques nm seulement dans la zone amincie 34.

Les connexions métalliques (ou en silicium) avec les régions de source et drain, et la grille de commande n'ont pas été représentées sur la figure 2.

En revenant à la figure 1, on va maintenant expliquer le fonctionnement de la cellule de mémoire ainsi décrite.

L'alimentation continue normale est d'environ 5 volts entre les bornes B et A et la bascule prend soit un état tel que la sortie Q soit à Vdd (5 volts) et la sortie R à Vss (0 volt), soit l'état inverse (Q à 0 volt, R à 5 volts). Cet état est imposé, en mode d'écriture, par la tension 0 ou 5 volts présente sur la ligne de bit LB et la tension complémentaire 5 volts ou 0 présente sur la ligne de bit complémentaire LB*, lors de la mise en conduction des transistors T7 et T8 commandés par la ligne de mot LM.

Un état donné étant mis en mémoire, il peut être lu également par mise en conduction des transistors T7 et T8 à partir de la ligne de mot LM, les lignes de bit LB et LB* transmettant alors les niveaux des sorties Q et R donc l'état de la bascule.

Pour effectuer une sauvegarde de l'état de la bascule, on fait passer temporairement (pendant 10 à 20 ms par exemple) la tension Vdd à une valeur élevée VH, de l'ordre de 20 volts.

Ce passage de Vdd à 20 volts peut être effectué soit automatiquement lors de la détection d'une coupure de courant, soit systématiquement à chaque changement d'état de la bascule (pour un compteur par exemple), soit sous l'effet d'un ordre de sauvegarde émis volontairement.

Si la sortie Q était au niveau bas, et la sortie R au niveau haut, on voit qu'il apparaît 20 volts sur la grille de commande GC et 0 volt sur la source du transistor T6. Ce dernier est rendu conducteur tandis que le transistor T5 (à canal p) est bloqué. Une injection d'électrons a lieu dans la grille flottante à travers la zone isolante amincie 34. La grille se charge négativement et modifie la tension de seuil apparente (vue de la grille de commande) des transistors T5 et T6: la tension de seuil du premier diminue de quelques volts, celle du second augmente de quelques volts. Pour une même tension appliquée par la suite sur la grille de commande, le transistor T5 présentera une résistance interne plus faible que le transistor T6.

Dans ces conditions, lorsqu'on voudra repositionner la bascule pour retrouver l'information sauvegardée, par exemple lors du rétablissement de l'alimentation, on s'arrangera pour que Vdd passe de 0 à 5 volts, les transistors T7 et T8 étant bloqués pour isoler la bascule des lignes de bit. Cette variation de tension est transmise par la capacité C au point M. Entre le point M et la borne d'alimentation B, on trouve l'équivalent de deux ponts diviseurs, l'un constitué par les transistors T5 et T4, l'autre par les transistors T6 et T3. Les transistors T3 et T4 sont identiques et au départ présentent des résistances a priori équivalentes. Mais le transistor T5 est plus conducteur que le transistor T6. Le potentiel du point R monte donc au départ plus vite que celui du point Q. Cette dissymétrie initiale suffit à faire basculer franchement la bascule dans un état correspondant à la sortie Q à Vss (0 volt) et la sortie R à Vdd. On remarque que le repositionnement correspond bien à l'état initial avant sauvegarde, et non à l'état inversé.

Si au contraire on était parti d'un état initial où la sortie R est à 0 volt et la sortie Q à 5 volts, le passage de Vdd à VH = 20 volts provoque une différence de potentiel de 20 volts entre grille de commande GC et source du transistor à canal n T6, dans un sens tendant à expulser les électrons de la grille flottante à travers la couche isolante amincie. Cette expulsion charge positivement la grille flottante de sorte que la tension de seuil apparente du transistor à canal p T5 augmente et celle du transistor à canal n T6 diminue. Pour une même tension appliquée sur la grille de commande GC, le transistor T6 présentera une plus faible résistance interne que le transistor T5.

Lorsqu'on repositionne la bascule en faisant passer Vdd de 0 à 5 volts, la variation de tension de Vdd est transmise par la capacité C au point M. Dans les ponts diviseurs constitués entre le point M et la borne B par les transistors T5 et T4 d'une part, T6 et T3 d'autre part, on voit qu'initialement T3 et T4 présentent des résistances sensiblement identiques, tandis que T6 a une résistance beaucoup plus faible que T5. Ce déséquilibre initial porte la sortie Q à un potentiel plus élevé que la sortie R et suffit à faire basculer franchement la bascule bistable dans un état où la sortie Q est à Vdd et la sortie R à Vss, ce qui correspond bien à l'état initial qu'on voulait sauvegarder.

En pratique, la capacité C doit avoir une valeur assez faible (mais suffisante pour transmettre au point M les variations de tension de Vdd), afin de ne pas gêner la vitesse d'écriture en fonctionnement normal (RAM statique) de la cellule: en effet, l'un des deux transistors T5 et T6 est rendu normalement conducteur en permanence par les charges présentes sur la grille flottante et, si on force les sorties R et Q à des valeurs données, la capacité C doit se charger en conséquence lors de l'écriture.

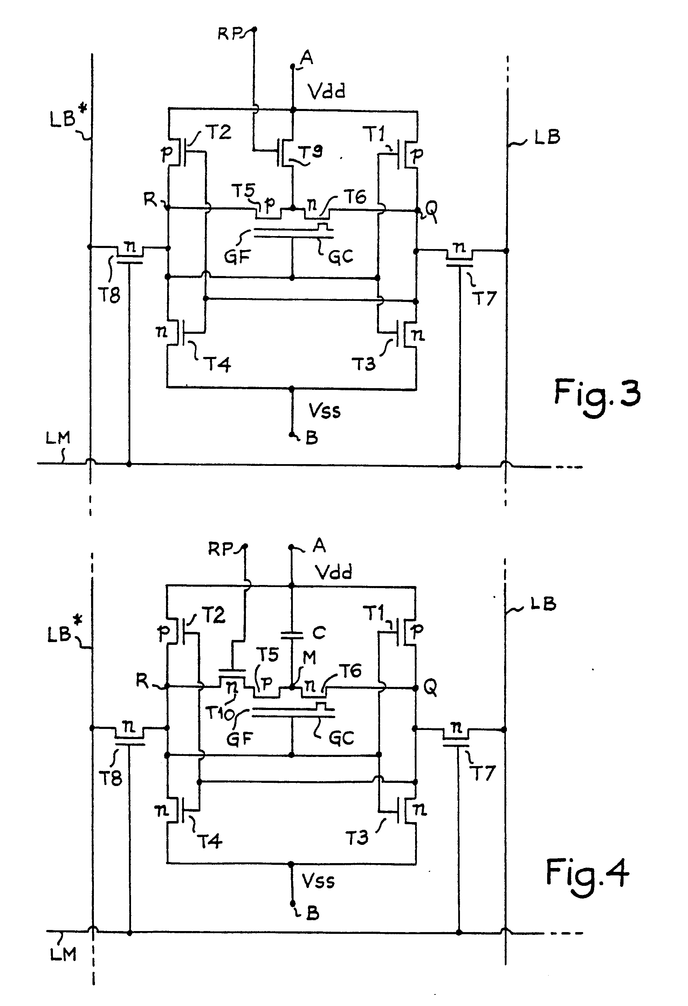

Pour éviter cet inconvénient, on peut prévoir une variante de réalisation représentée à la figure 3, dans laquelle le condensateur C a été remplacé par un transistor T9, à canal n, en série entre le point M et la borne A, ce transistor étant rendu conducteur par un signal RP de commande de repositionnement; en dehors de la phase de repositionnement, le transistor T9 est bloqué; pendant la phase de repositionnement, on fait passer Vdd de 0 à 5 volts en maintenant T9 conducteur par le signal RP.

La figure 4 montre une autre variante dans laquelle un transistor T10 a été inséré dans la branche de mémorisation non volatile, en série avec les transistors T5 et T6 entre les sorties Q et R: le transistor T10, à canal n, est relié à la borne R et sa grille reçoit un signal de repositionnement RP qui le rend conducteur uniquement pendant les phases de repositionnement. Pendant ces phases, le transistor T10 est suffisamment conducteur (sa dimension est choisie en conséquence) pour ne pas fausser la disymétrie de conduction des transistors T5 et T6. Mais, pendant la phase de sauvegarde non volatile, il permet d'être certain, dans le cas où le transistor T5 est conducteur (sortie R à 0 volt), que la différence de potentiel entre les points R et Q est suffisamment importante pour ne pas arrêter prématurément l'évacuation d'électrons de la grille flottante.

La réalisation de la figure 4 peut aussi se combiner avec celle de la figure 3, c'est à dire que la capacité C peut être remplacée par le transistor T9 commandé comme le transistor T10 pour le signal RP.

Pour la même raison que dans le cas de la figure 4, on peut également remplacer le transistor T10, commandé par un signal de repositionnement, par un couple de transistors en série, l'un ayant sa source et sa grille reliées à la sortie R, l'autre ayant sa grille reliée au point M. On peut aussi prévoir, dans ce cas, encore un transistor supplémentaire, en série entre le transistor T6 et la sortie Q et ayant sa grille reliée à la sortie Q, pour équilibrer les demi-branches entre M et R et entre M et Q lors du repositionnement.

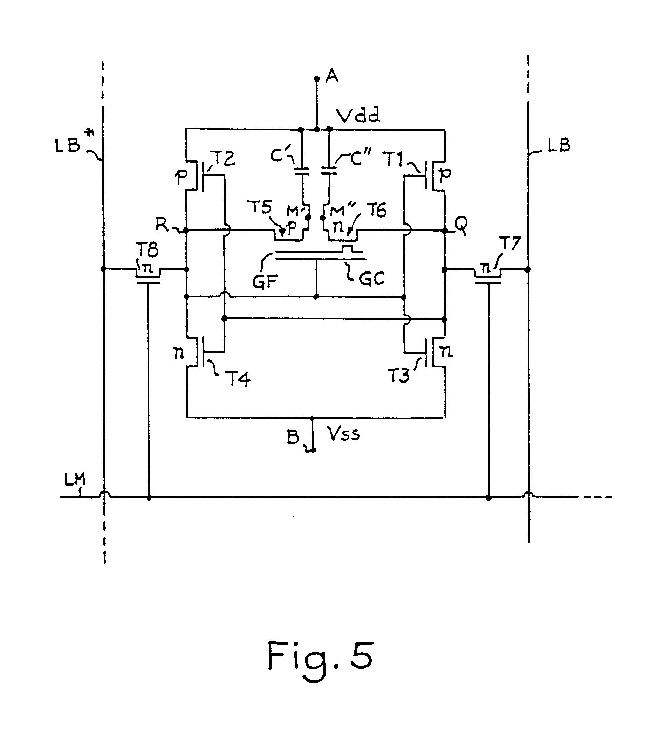

Enfin, la figure 5 représente encore une autre variante de réalisation dans laquelle les transistors T5 et T6 ne sont pas directement reliés ensemble, mais reliés chacun par son drain à une capacité respective (C' et C") ou un transistor respectif, reliés par ailleurs à la borne A. Ces capacités ou ces transistors jouent le même rôle que la capacité C ou le transistor T9 et correspondent en fait à un dédoublement de la capacité C ou du transistor T9. Les capacités C' et C" sont identiques; si ce sont des transistors qui remplacent les capacités C' et C", ces transistors sont commandés par le signal de repositionnement RP. Dans le cas de la figure 5, il n'y a donc pas de connexion directe entre les drains 16 et 26 (figure 2) des transistors complémentaires. Cette réalisation de la figure 5 évite le passage de courant dans les transistors complémentaires lors de la phase de sauvegarde. Elle évite aussi de prévoir un transistor tel que T10 et sa ligne de commande.

## Revendications

1. Cellule de mémoire non volatile, comprenant une bascule bistable à deux sorties complémentaires (R et Q) alimentée par une tension continue (Vss, Vdd), comportant un élément de mémorisation non volatile (T5, T6) constituée de deux transistors MOS en série connectés entre les deux sorties complémentaires de la bascule, la cellule comportant encore un moyen (C, T9) pour appliquer temporairement un potentiel d'alimentation au point de jonction (M) de ces deux transistors, caractérisé en ce que les transistors en série sont des transistors complémentaires, à savoir un transistor à canal n (T6) et un transistor à canal p (T5), ces deux transistors ayant une grille flottante commune (GF) recouvrant leurs régions de canal (18, 28), et isolée d'elles par une première couche isolante mince (20, 30), et une grille de commande commune (GC) recouvrant la grille flottante et isolée d'elle par une deuxième couche isolante mince (22, 32), la première couche isolante présentant une zone mince d'injection (34) du côté de la région de source (24) de l'un des transistors complémentaires, cette région de source étant reliée à une première sortie (Q) de la bascule et la grille de commande étant reliée à la deuxième sortie (R).

2. Cellule selon la revendication 1, caractérisé en ce qu'une capacité (C) est connectée entre le point de jonction (M) des deux transistors complémentaires en série et une borne d'alimentation (A) de la cellule.

3. Cellule selon la revendication 1, caractérisée en ce qu'un transistor (T9) est connecté entre le point de jonction (M) des deux transistors complémentaires en série et une borne d'alimentation (A) de la cellule, la grille de commande de ce transistor recevant un signal de repositionnement (RP).

4. Cellule selon la revendication 1, caractérisée en ce que la zone mince (34) est prévue au-dessus de la source du transistor à canal n.

## Patentansprüche

1. Nichtflüchtige Speicherzelle, mit einer bistabilen Kippschaltung, die zwei komplementäre Ausgänge (R und Q) aufweist, gespeist durch eine Gleichspannung (Vss, Vdd), mit einem nichtflüchtigen Speicherelement (T5, T6), welches durch zwei in Reihe geschaltete MOS-Transistoren gebildet ist, die zwischen die zwei komplementären Ausgänge der Kippschaltung geschaltet sind, wobei die Zelle ferner ein Mittel (C, T9) umfaßt, um vorübergehend ein Versorgungspotential an den Verbindungspunkt (M) zwischen diesen zwei Transistoren anzulegen, dadurch gekennzeichnet, daß die in Reihe liegenden Transistoren komplementäre Transistoren sind, nämlich ein Transistor mit n-Kanal (T6) und ein Transistor mit p-Kanal (T5), wobei diese zwei Transistoren ein gemeinsames schwimmendes Gate (GF) aufweisen, welches ihre Kanalzonen (18, 28) bedeckt und von ihnen durch eine erste dünne Isolierschicht (20, 30) isoliert ist, und ein gemeinsames Steuergate (GC) aufweisen, welches das schwimmende Gate bedeckt und von ihm durch eine zweite dünne Isolierschicht (22, 32) isoliert ist, wobei die erste Isolierschicht eine dünne Injektionszone (34) auf der Seite der Source-Zone (24) eines der komplementären Transistoren aufweist und wobei diese Source-Zone mit einem ersten Ausgang (Q) der Kippschaltung verbunden ist und das Steuergate mit dem zweiten Ausgang (R) verbunden ist.

2. Zelle nach Anspruch 1, dadurch gekennzeichnet, daß eine Kapazität (C) zwischen den Verbindungspunkt (M) zwischen den zwei komplementären Transistoren, die in Reihe liegen, und einen Versorgungsanschluß (A) der Zelle geschaltet ist.

3. Zelle nach Anspruch 1, dadurch gekennzeichnet, daß ein Transistor (T9) zwischen den Verbindungspunkt (M) zwischen den beiden komplementären in Reihe liegenden Transistoren und einen Versorgungsanschluß (A) der Zelle geschaltet ist, wobei das Steuergate dieses Transistors ein Wiedereinstellsignal (RP) empfängt.

4. Zelle nach Anspruch 1, dadurch gekennzeichnet, daß die dünne Zone (34) oberhalb der Source-Elektrode des n-Kanal-Transistors vorgesehen ist.

## Claims

1. Non-volatile memory cell, comprising a bistable circuit having two complementary outputs (R and Q) supplied by a direct voltage (Vss, Vdd), comprising a non-volatile memory element (T5, T6) formed of two series connected MOS transistors connected between the two complementary outputs of the bistable circuit, the cell further comprising a means (C, T9) to temporarily apply a supply potential to the junction point (M) of these two transistors, characterized in that the series connected transistors are complementary transistors, i.e. a n-channel transistor (T6) and a p-channel transistor (T5), these two transistors having a common floating gate (GF) covering their channel regions (18, 28) and insulated therefrom by a first thin insulating layer (20,30), and a common control gate (GC) covering the floating gate and insulated therefrom by a second insulating thin layer (22, 32), the first insulating layer having a thin injection zone (34) on the side of the source region (24) of one of the complementary transistors, this source region being connected to a first output (Q) of the bistable circuit and the control gate being connected to the second output (R).

2. Cell according to claim 1, characterized in that a capacity (C) is connected between the junction point (M) of the two complementary series connected transistors and a supply terminal (A) of the cell.

3. Cell according to claim 1, characterized in that a transistor (T9) is connected between the junction point (M) of the two complementary series connected transistors and a supply terminal (A) of the cell, the control gate of this transistor receiving a repositioning signal (RP).

4. Cell according to claim 1, characterized in that the thin zone (34) is provided above the source of the n-channel transistor.

Fig.1

Fig.2

Fig.3

Fig.4

3

Fig. 5